# EUROPEAN PATENT APPLICATION

(11) **EP 4 679 109 A1**
(43) Date of publication of application: **14.01.2026**
(21) Application number: 24187545.9
(22) Date of filing: 09.07.2024
(51) Int. Cl.: G01R 31/28, G01R 19/00, G01R 29/08

(54) **APPARATUS FOR MEASURING ELECTRICAL CHARACTERISTICS**

(71) Applicant: Aptiv Technologies AG, 8200 Schaffhausen (CH)
(72) Inventor: SCISLOWSKI, Andrzej, 8200 Schaffhausen (CH); MALINA, Jakub, 8200 Schaffhausen (CH)
(74) Representative: Lewis Silkin LLP

(57) **Abstract**

A measurement apparatus is described which has a base board to host a plurality of circuit boards containing measurement circuitry for measuring current and voltage information of a device under test, on a plurality of channels. The apparatus is suitable for mounting in a test rack as a modular system for measuring electrical parameters of a plurality of devices during electromagnetic compatibility tests.

## Description

### Field

The present disclosure relates to an apparatus for measuring electrical characteristics of a plurality of devices. The present disclosure particularly relates to a measurement apparatus which has a base board to host a plurality of circuit boards containing measurement circuitry for measuring current and voltage information on a plurality of channels. The present disclosure further relates to a test rack for receiving the plurality of devices and for hosting a plurality of measurement apparatuses.

### Background

Environmental testing of a device typically includes mounting the device to a test rack, in which the environmental conditions to which the device can be expected to be exposed, in use, are simulated. The performance of the device is assessed based on measurements of electrical characteristics of the device, derived from current and voltage measurements by measurement cards in the test rack. For efficiency, a plurality of devices under test are mounted to the test rack, typically six, and a plurality of measurement cards are used.

According to particular test requirements, national standards, customer requirements and best practices, all test units must be continuously monitored at much higher frequency than anticipated electromagnetic interferences in the test rack, which places a burden on the design of the measurement cards in the test rack. Further, there are a number of highly specific requirements tailored to particular use cases, such as those prescribing accuracy and range of measurement, a robust communication protocol, response times, physical requirements, reconfigurability and storage of calibration parameters, which further constrain the design of the measurement cards.

In view of the above requirements, where there is a need for simultaneous integration, testing and validation of multiple units, existing solutions suffer from a number of disadvantages. In particular, existing solutions may be expensive, have low accuracy, and use communication systems with limited measurement frequencies, and a high number of physical connections. In particular, a large number of connections can cause communication losses and compatibility difficulties, as well as excessive physical size. Additionally, current consumptions of testing units can affect current-measurement reliability and cause errors to be introduced.

Embodiments of the present disclosure present a measurement apparatus which aims to address at least some of the disadvantages set out above.

### Summary

According to an aspect of the present disclosure, there is provided an apparatus for measuring electrical characteristics of a test system, comprising a base board arranged to host a plurality of circuit boards, each circuit board comprising a measurement module, the base board comprising an interface for connection with the test system, wherein the interface is arranged to receive a current, on a current channel, from the test system, and a plurality of voltages, on a respective plurality of voltage channels, from the test system, wherein the plurality of circuit boards comprises one or more voltage testing modules, each voltage testing module comprising a plurality of voltage measurement units, and each voltage measurement unit for measuring a voltage on a respective voltage channel, a current testing module comprising a current measurement unit for measuring a current on the current channel, wherein the interface is arranged to output voltage information from the one or more voltage testing modules and current information from the current testing module.

In this way, the apparatus can replace several conventional measurement cards, with enhanced measurement capabilities, and possibilities for device validation.

In embodiments, each of the one or more voltage testing modules comprises a sampler for sampling the voltage on a voltage channel, an analogue to digital converter for determining a digital voltage level for the sampled voltage, and a storage means for storing the digital voltage level, wherein the interface is arranged to output the stored digital voltage level for each voltage channel in parallel.

In this way, voltage measurements for a plurality of channels, such as those associated with different devices, or those associated with different signal paths within a single device, can be obtained simultaneously and stored for further processing into a test report. Further, it is possible to tailor measurement parameters for each channel to optimise performance, enabling high frequency error detection.

In embodiments, the storage means is arranged to store an average of a plurality of digital voltage levels and the interface is arranged to output the stored average. In this way, the effect of short-term fluctuations in measured voltage levels can be removed. The increased measurement frequency associated with embodiments of the present disclosure in comparison with conventional disclosures enables sufficient data points to be recorded that averaging is possible.

In embodiments, the current measurement module comprises a plurality of current measurement channels, wherein each current measurement channel is for measuring current within a predetermined range, the current measurement module comprising a selector for automatically routing the current channel to a current measurement channel in dependence upon the level of the current to be measured. In this way, an enhanced range of current measurements is obtained.

In embodiments, each current measurement channel comprises a shunt resistor having a resistance dependent on the predetermined range of the current measurement channel; and an instrumentation amplifier for measuring a voltage across the shunt resistor when current passes through the shunt resistor, wherein the selector is arranged to switch the current channel from a first current measurement channel to a second current measurement channel if a voltage output by an instrumentation amplifier of the first current measurement channel exceeds a threshold. In this way, continuous current measurement is achieved when switching between different current ranges.

In embodiments, the shunt resistors are connected in series, wherein the shunt resistor of the first current measurement channel is connected in parallel with a bypass switch arranged to close if the voltage output by the instrumentation amplifier of the first current measurement channel exceeds the threshold.

In embodiments, the resistances of the shunt resistors are selectable via a control signal received by the current testing module in dependence on selection of the predetermined current measurement range of each current measurement channel.

In embodiments, the apparatus further comprises a sampler for sampling a voltage output by the instrumentation amplifier of a current measurement channel, an analogue to digital converter for outputting a digital current level corresponding to each sampled voltage and the resistance of the shunt of the current measurement channel, and a storage means for storing the digital current levels, wherein the interface is arranged to output the stored digital current levels.

In embodiments, the storage means is arranged to store an average of a plurality of digital current levels and the interface is arranged to output the stored average. In this way, the effect of short-term fluctuations in measured current levels can be removed. The increased measurement frequency associated with embodiments of the present disclosure in comparison with conventional disclosures enables sufficient data points to be recorded that averaging is possible.

According to a further aspect of the present disclosure, there is provided a test rack comprising an electromagnetic compatibility chamber, and a plurality of apparatuses according to any one of the preceding claims, wherein the plurality of apparatuses are mounted within the electromagnetic compatibility chamber and each one of the plurality of apparatuses is arranged to measure electrical characteristics of a respective test system to be mounted to the test rack. The modular build of each apparatus described above enables flexibility in the number of apparatuses which are mounted to the test rack, while each apparatus has low electromagnetic emissions enabling direct positioning within the test rack.

In embodiments, the interface of each apparatus is arranged to connect to the respective test system using an ethernet connection or optical fibre connection. These connections are robust, and high-speed, facilitating connection to an external computing device for receiving and processing test data.

In embodiments, each apparatus is arranged to output information identifying the address of the apparatus in the test rack. With such automatic identification, errors are reduced as it is not necessary for a user to manually label test data as being associated with a particular apparatus.

In embodiments, the test rack comprises a backplane for receiving the respective plurality of base boards of the plurality of apparatuses. In this way, each apparatus is connectable to the test rack in an interchangeable and robust manner, with shortened signal path lengths than would be possible using wired connections.

In embodiments, the test rack is arranged to receive a plurality of automotive infotainment systems as the test systems.

### Brief description of drawings

Illustrative embodiments will now be described with reference to the drawings in which:
Figure 1 shows an apparatus for measuring electrical characteristics of a test system according to a first embodiment;
Figure 2 shows details of the voltage testing module and the current testing module of the measurement apparatus of the first embodiment;
Figure 3 shows an automatic range selector of the current testing module of the measurement apparatus of the first embodiment; and
Figure 4 shows a test rack according to a second embodiment, to which a plurality of measurement apparatuses are mounted.

### Detailed description

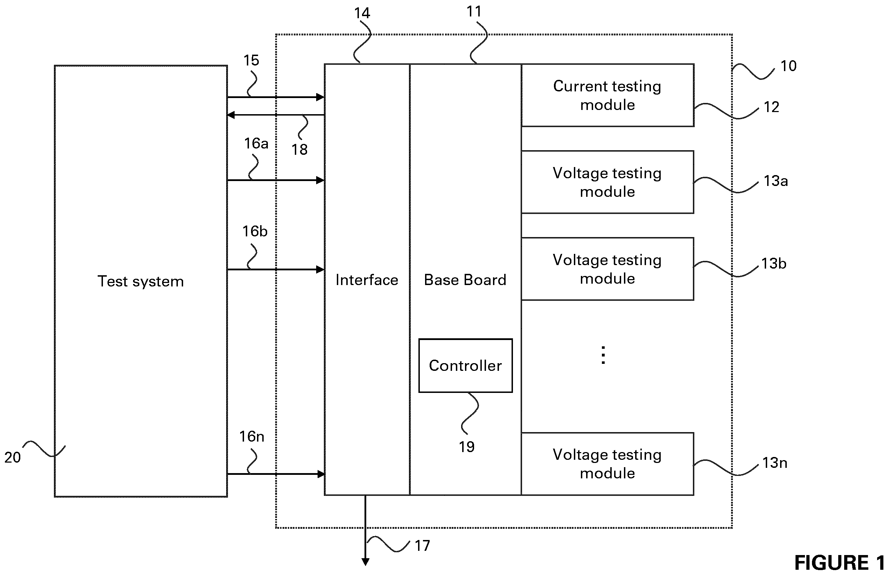

Figure 1 shows an apparatus 10 for measuring electrical characteristics of a test system 20 according to a first embodiment of the present disclosure. The electrical characteristics are primarily voltage and current measurements, from which operating statuses, functions, device performance levels and the like can be derived.

The measurement apparatus 10 comprises a base board 11, which hosts a plurality of circuit boards including a current testing module 12, and a plurality of voltage testing modules 13a, 13b, ..., 13n. The base board is analogous to a motherboard used in a computing system, and acts as a substrate or backplane to which a plurality of circuit board modules in the form of removable 'cards', are physically attached via slots or sockets. High-speed connections between each card interface and a central controller 19 are provided on the base board, as printed circuit tracks or interconnections forming a data bus.

The plurality of circuit boards provide the measurement apparatus 10 with functionality for measuring electrical characteristics of the test system 20, based on signals exchanged between the test system 20 and the measurement apparatus 10 via an interface 14. The controller 19 of the base board 11 controls operations of the measurement apparatus 10, and signal and data flows to and from each circuit board module, to be described in more detail below.

The test system 20 comprises either a single system comprising a plurality of components, a collection of independent devices operating in parallel or in combination, or a system comprising a mixture of standalone devices and integrated devices. Generally, the test system 20 is generalized herein via the term 'device under test' (DUT), characterized by the output of signals on a current channel 15 and a plurality (n) of voltage channels 16a, 16b, ..., 16n. A return current channel 18 returns current back to the DUT 20 to enable the DUT to operate using its current supply during current testing.

The channel signals are received from the DUT 20 via the interface 14, which routes them, via the base board 11, to the circuit boards 12, 13a-n for testing. The testing results are provided back to the base board 11 and the interface 14, for provision as an output 17 from the measurement apparatus 10. The output 17 is provided to any appropriate results-processing system (not shown), such as a computing system or dashboard, which tracks, processes and/or displays diagnostic information for the DUT 20.

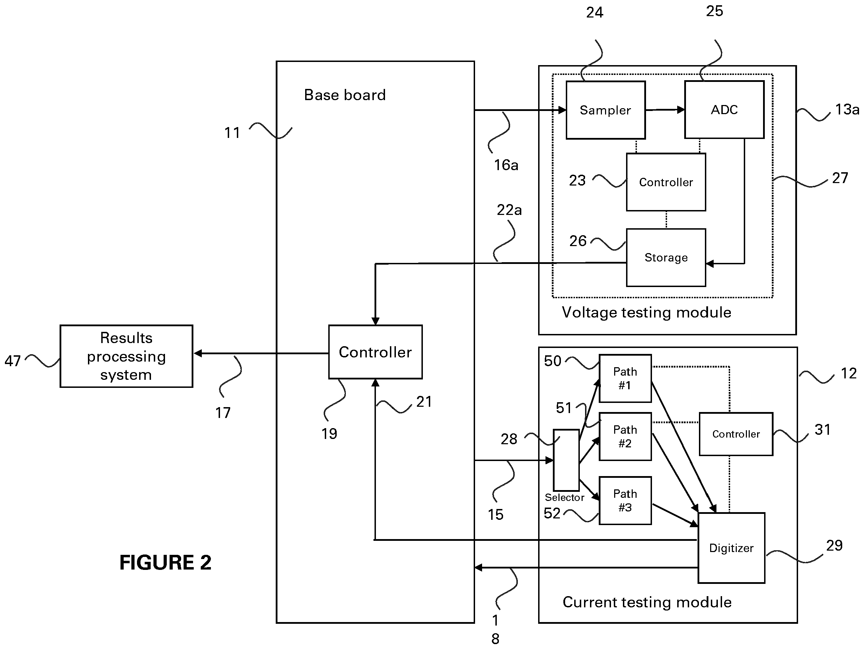

Figure 2 illustrates details of the current testing module 12 and one of the voltage testing modules 13a of the apparatus of the first embodiment, with the same design being applied, in embodiments, to the plurality of voltage testing modules 13a-n connected to the base board 11. The connections between the DUT 20 and the base board 11 are not shown, for simplicity. The controller 19 outputs measurement results to a results-processing system 47.

The voltage testing module 13a receives an analogue direct current (d.c.) voltage signal on channel 16a from the base board 11, measures the voltage and returns the measurement over a return channel 22a to the controller 19. The input channel 16a and the return channel 22 are both carried on the physical connection between the voltage testing module 13a and the base board 11. The current testing module 12 receives current on a current channel 15 from the base board 11, measures the current and returns the measurement over a return channel 21 to the controller 19. The current path is returned to the DUT 20 via path 18, via the base board 11.

The voltage testing module 13a comprises a controller 23, which controls operation of a sampler 24 and an analogue-to digital converter (ADC) 25 for digitizing samples taken by the sampler. The digitized samples are stored in a memory 26, and the controller 23 of the voltage testing module 16a controls provision of stored measurement results to the base board 11. Each of the components of the voltage testing module 16a illustrated in Figure 2 is grouped as part of a voltage measurement unit 27. In embodiments, the voltage testing module 13a comprises a plurality of voltage measurement units 27, each unit 27 receiving information on a different voltage channel and making a measurement of the channel. In some embodiments, each voltage measurement unit 27 comprises its own controller 23, but in other embodiments, the voltage testing module 13a comprises a single controller which controls voltage measurement units comprising the sampler 24, the ADC 25 and the storage 26, in parallel.

The current testing module 12 receives current on a current path 15, and a selector 28 routes the current to one of three current paths 50, 51, 52 for measurement of the current. In some embodiments, more than three paths are present. The measured current is sampled, digitized and stored by a digitizer 29, which comprises components analogous to the sampler 24, ADC 24 and storage 26 of the voltage testing module. A single digitizer is shown for simplicity and separate components are present embodiments, but in alternative embodiments, the sampler 24, ADC 25 and storage 26 are analogously integrated into a single digitizer module. The digitizer 29 contains a bypass module for passing measured current back to the DUT via a return current channel 18, via the base board 11. The digitizer also outputs a digital measurement of the current over measurement channel 21 to the controller 19 of the base board. Channels 15, 18 and 21 are each carried on the physical connection between the current testing module 12 and the base board 11. Operation of the current testing module 12 is controlled by a controller 31.

By way of example, the measurement apparatus 10 of the first embodiment is arranged to test electrical characteristics of an automotive infotainment system, comprising components such as a radio, audio playback system, speakers, display, and a communication system. The infotainment system consumes current, sourced by a vehicle's power supply system or battery when the infotainment system is in use. If the infotainment system is configured as an integrated module which is removable from the vehicle, the module can be inserted into a test rack, and supplied current by a test current source instead of by the vehicle's battery.

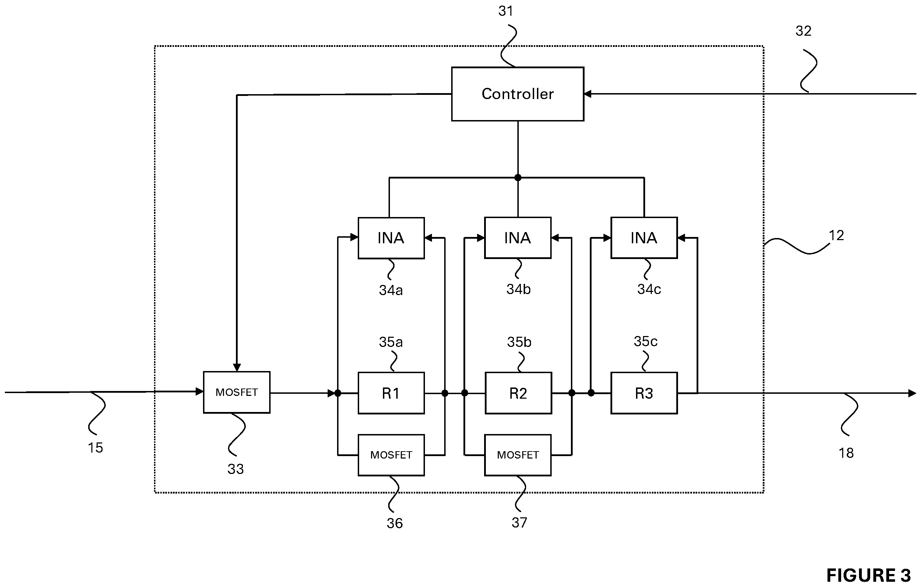

The current which is consumed by the infotainment system varies in dependence on the features which are active. For example, if the speakers are switched off, only a small current such as 100µA is consumed. If the speakers and a wireless audio streaming module are operational, the consumed current may exceed 10A. Conventionally, it is difficult to measure such different currents accurately, as the range of typical measuring devices is not large enough to allow for the range of currents which is expected. The current testing module 12 of the measurement apparatus 10 of the first embodiment includes a mechanism to address this problem, as described with reference to Figure 3.

Figure 3 shows details of the current testing module 12 of the measurement apparatus 10 of the first embodiment, and specifically an automatic range selector for measurement of current in a selected range. The operation of the current testing module 12 is controlled by a controller 31, which receives a control signal 32 from an external control system (not shown). The external control system may be the same system as the results-processing system which receives the output 17 of the measurement apparatus 10 shown in Figure 1. In embodiments, the control signal 32 is a universal asynchronous receiver / transmitter (UART) control signal, enabling control inputs to be provided as human-readable text string commands, such as 'MEASURE VOLTAGE'. In this way, no dedicated software is needed in order to be able to operate the current testing module 12.

Current testing module 12 receives an input from the DUT 20 on the current channel 15. The current channel 15 carries a current which is current consumed by the DUT 20 during operation, and which is returned to the DUT by return current channel 18. In embodiments, the current is in the range of 10µA-16A. The signal path between channel 15 and channel 18 is a diversion of the current consumed by the DUT 20 through the current testing module 12, and the diversion is controlled by a switch or transistor 33. The diversion of current into a measurement path ensures that signals can be measured without affecting the signal source at the DUT 20. In the first embodiment, the transistor 33 is a metal-oxide-semiconductor field-effect-transistor (MOSFET) with a low drain-source on-resistance (less than 1 mΩ). When the MOSFET 33 is switched on by a control signal from the controller 31, current received on the current channel 15 passes into the current testing module 12.

The current is derived from the voltage which drops across a shunt resistor, using Ohm's law. The voltage drop is measured using one of three instrumentation amplifiers (INA) 34a, 34b, 34c, each arranged to sense a voltage drop across respective shunt resistor 35a (R1), 35b (R2), and 35c (R3). INAs are selected for their high accuracy and low noise.

The three shunt resistors 35a-c have different resistances, which define three different current measurement ranges. Input current which is passed by MOSFET 33 flows through a first current measurement path 50 through a first resistor 35a, and measured by a first INA 34a. If the input current is such that it causes a voltage drop across the first resistor 35a which exceeds a first threshold voltage, MOSFET or bypass switch 36 is turned on, which causes the current to bypass first shunt resistor 35a. The controller 31 does not sense a voltage using INA 34a, and the current passes to a second current measurement path 51 which includes second shunt resistor 35b.

If the current in the second current measurement path 51 is such that it causes a voltage drop across the second resistor 35b which exceeds a second threshold voltage, MOSFET or switch 37 is turned on, which causes the current to bypass the second shunt resistor 35b. The controller 31 does not sense a voltage using INA 34b, and the current passes to a third current measurement path 52 through third shunt resistor 35c, where it causes a voltage drop which is sensed by INA 34c.

In the first embodiment, R1 > R2 > R3. In this way, if the input current is in the lowest of three measurement ranges (such as that expected from a sleep mode, it will be insufficient to cause a voltage drop across the first shunt resistor 35a which exceeds the first threshold, and in this instance, the voltage drop across R1 is measured by the first INA 34a.

If the current is in the intermediate measurement range, such as that expected from a standby or idle mode, it will cause a voltage drop across the first shunt resistor 35a which exceeds the first threshold, but it will not cause a voltage drop across the second shunt resistor 35b which exceeds the second threshold voltage. In this instance, the voltage drop across R2 is measured by the second INA 34b.

If the input current is in the highest measurement range, such as that expected from a power-on mode, it will cause a voltage drop across the first shunt resistor 35a which exceeds the first threshold, and it will also cause a voltage drop across the second shunt resistor which exceeds the second threshold. In this instance, the voltage drop across R3 is measured by the third INA 34c.

In this way, the range of voltages which are measured by the three INAs need not differ significantly from each other, because the measured voltages are a product of either a high current and a low resistance, a low current and a high resistance, or an intermediate current and an intermediate resistance. In contrast, if the current test module 12 contained only a single current measurement path, the range of voltages to be measured by the INA would be proportional to the range of currents consumed by the DUT.

Further, constraining each INA 34a-c to measuring a particular current range optimizes power consumption associated with the measurement of high current, following the expression P = I²R, for power P, current I, and resistance R. The largest currents are measured through the smallest shunt resistance. In comparison to a conventional system using a single measurement path with constant resistance, this causes a significant saving in power consumption as the conventional system would not have a mechanism to reduce power consumption for measurement of large currents.

The operation of the current test module 12 is based on an automatic range selector, in which the activation of MOSFETs 36 and 37 is performed automatically as a result of the current passing through resistances 35a and 35b respectively. In this way, switching between the measurement range can occur seamlessly, without interruption of measurement. The transition between ranges is managed by the controller 31. In embodiments, the controller 31 comprises a plurality of discrete embedded integrated circuits which work independently and do not require external control software, or control by the controller 19 of the base board 11. In this way, activation of the MOSFETS 36, 37 and switching of the range measurements occurs extremely quickly. Further, the current path is protected against any fast current spikes that might occur, because high currents can be switched to the third shunt resistor 35c without causing excessive power dissipation. Functionally, the automatic range selection operation represented by Figure 3 is represented by selector 28 of Figure 2 and the three measurement paths 50, 51 and 52.

Although three INAs and shunt resistors are illustrated in Figure 3, in alternative embodiments, a different number of shunt resistors and INAs can be used, where a larger range of currents is to be measured. The operating principle remains as described above. The shunt resistances are configured such that the current testing module 12 tests the most common expected current consumptions, for a given DUT and its operating modes, as the different current measurement ranges. As such, the current ranges do not need to be of equal size. In embodiments, resistances R1, R2 and R3 are programmable via control signal 32. In this way, current measurement ranges can be adjusted in anticipation of a different DUT 20.

The controller 31 of the current testing module 12 operates to control digitizer 29 to store a time-series of digitized sampled current measurements, derived by dividing the voltage across an INA by the resistance of the respective shunt resistor. The time-series is output by the digitizer 29 over measurement channel 21 as shown in Figure 2, and onward to the output 17 of the measurement apparatus 10. The time-series enables rapid changes in current to be detected, enabling early identification of errors or uncharacteristic behaviours of the DUT. The time-series can be averaged based on operation of the controller 31 where it is not necessary to have such a high-frequency record of characteristics of the DUT and where fluctuations are to be eliminated.

The measurement apparatus 10 of the first embodiment is capable of receiving 16 voltage channel measurements from the DUT 20, which represent 16 different d.c. voltages at particular portions of the circuitry of the test system 20. In some embodiments, the d.c. voltages represent particular subsystem supply voltages for subsystems of the infotainment system, but in other embodiments, one or more voltage channels may additionally or alternatively comprise output voltages representing particular device states or functional outputs.

The different voltage channels are received by the measurement apparatus 10 on respective pins of a physical connector forming the interface 11. The pins interface with sockets on a corresponding connector, such as that of a diagnostics interface, which is attached to the DUT 20. In embodiments, the pins of interface 11 are, alternatively, sockets arranged to receive corresponding pins of a connector attached to the test system.

In embodiments, the measurement apparatus 10 has one voltage testing module 13a, 13b, ..., 13n for each channel 16a, 16b, ..., 16n. In other embodiments, one or more of the voltage testing modules 13a, 13b, ..., 13n may each operate on a plurality of voltage channels, using a plurality of voltage measurement units on a single circuit board, as described in more detail below.

Each voltage testing module 13a-n is for testing d.c. voltages in the range of 0-35V. As with the output of current information, digitized voltage samples on each channel may be output as a high-frequency time series, and a plurality of data points may be averaged, either by a controller 23 of each voltage testing module, a controller of a voltage measurement unit 27.

In embodiments, the base board 11 is configured such that voltage measurements for each channel are output in parallel. To achieve this, each voltage testing module 13a-n outputs its test data to the controller 19 of the base board 11 in parallel. The controller 19 prepares a data stream which is appropriate for the intended output 17 of electrical characteristic information for the DUT 20. The data stream may include one or more of a timestamp for each measurement result, card ID data stored in a memory on the base board 11, channel ID and any configuration or calibration data relating to firmware of the controller 19 or measurement ranges of the current testing module 12.

A connection such as an ethernet connection or optical fibre connection, or a sequence of ethernet and optical fibre connections, ensures speed of transmission of the data stream, and robustness of the connection to whichever external results-processing system is required to receive the data stream. As such, is possible to output electrical characteristics substantially in real time.

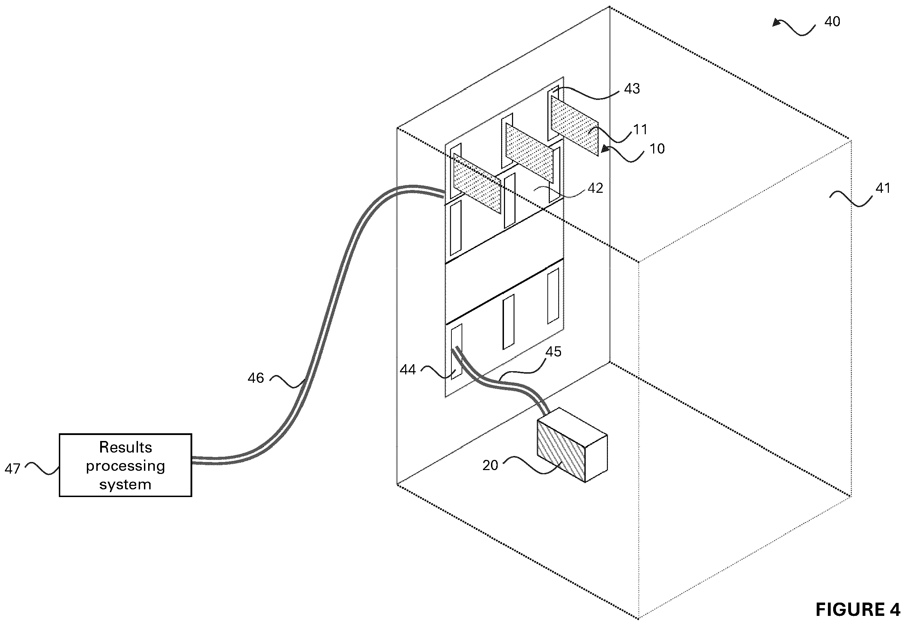

Rapid and robust communication of test results is particularly possible when the measurement apparatus 10 is mounted to a test rack 40, according to a second embodiment of the present disclosure, as illustrated in Figure 4. The test rack 40 of the second embodiment comprises an electromagnetic compatibility (EMC) test chamber 41, within which it is tested whether a plurality of DUTs are able to function in particular electromagnetic environments. The size of the test chamber 41 is exaggerated in Figure 4 for ease of explanation.

The test rack 40 comprises a backplane 42, to which a plurality of base boards 11, each of a respective measurement apparatus 10 of the first embodiment, are attached via a physical connector or socket 43 on the backplane 42. The circuit boards which are mounted to the base board 11 are not shown, for simplicity. The backplane 42 comprises a plurality of sockets 44 for receiving connections from a DUT 20 via a wire harness 45. In Figure 4, a single DUT 20 is illustrated, but it is possible to connect a plurality to DUTs to the respective plurality of sockets 44. The backplane 42 is configured such that each measurement apparatus 10 is connected to a respective DUT 20 via electrical connections of the backplane (not shown) in order to test its electrical characteristics. The sockets 43 and 44 are arranged in a plurality of rows in the test rack 40, and although three sockets are illustrated in each row in Figure 4, this is simply by way of example, and many more sockets may be present. The second row of the test rack 40 represents an expansion row in which additional measurement apparatuses 10 can be mounted.

The DUT 20 typically comprises its own interface and wire harness 45 which are connected to other system components, such as the circuit board of an electronic control unit of a vehicle, when the DUT 20 is in its normal operating environment. The same connector and wire harness 45 are used to connect the DUT 20 to the test rack 40, and as such, no modification to the DUT 20 is required in order to enable it to be used with the measurement apparatus 10 of embodiments of the present disclosure. A corresponding socket 44 receives the DUT's interface connector and routes the current and voltage channels to the measurement apparatus 10. When the measurement apparatus 10 outputs measurements to the external results processing system 47, the data stream which is output may contain channel identifiers to enable the specific physical pin signal of the connector of the DUT 20 to be identified.

The design of the measurement apparatus 10, and in particular the fact that it can be mounted directly in the test chamber 41, enables significant reduction in complexity over conventional systems in which EMC testing of a DUT is performed using testing equipment which is external to the EMC test chamber. Such conventional systems require additional connection components to transport signals from the DUT outside of the test chamber to the point of measurement of voltage and current signals, such as analogue-to-digital electro-optical converters in the test chamber, and digital-to-analogue opto-electrical converters outside of the test chamber, which increases the path length between the DUT and the system which processes the test results. The increased path length has a negative effect on the accuracy of the test results. Using the measurement apparatus 10 of the present embodiments, all of the test results can be multiplexed onto a single digital output 46 directly from the backplane 42 to a results-processing system 47. The results-processing system is thus able to validate results of an EMC test by tracking electrical characteristics of the devices under test from the received current and voltage measurements, as the EMC test progresses.

The physical dimensions of each base board 11 can be made to be compliant with industry standards for test racks 41 (such as 19" or 482.6mm width rack for mounting in a typical 3U height rack), while angled edge connectors, to be used as the main connector between the base board 11 and the socket 43 on the backplane 42, facilitates removal and replacement of the measurement apparatus 10. Generally, it will be appreciated that a design of this size and shape represents a compact, efficiently-sized measurement apparatus 10, enabling significant testing functionality to be accommodated within the test chamber 41.

The EMC emissions of the measurement apparatus 10 of the present embodiments are low, since there is no need to transmit an analogue test signal to be measured to an external device - only the measurement itself is transmitted as a data stream. In embodiments, EMC emissions of each measurement apparatus 10 are further reduced by metal shielding and/or electromagnetic interference filters mounted to and around the base board 11.

In embodiments, each measurement apparatus 10 in the test rack 40 is able to determine its position or address in the test rack 40 automatically. For example, the test rack 40 may have a particular resistor associated with each socket 43 on the backplane 42, whose resistance can be determined by a measurement apparatus 10 when mounted to the socket 43, with unique resistances present at each socket 43. The measurement apparatus 10 is therefore able to determine its position or address without the need to hard code any particular location on the apparatus 10 itself. Further, the possibility of human error in locating the measurement apparatus 10 is avoided, as the location of the measurement apparatus 10, and the identity of a corresponding DUT 20, can be appended to the rest results output from the test rack 40.

This facilitates interchange of the measurement apparatus 10 with a replacement, if a fault occurs, or if the measurement apparatus 10 requires servicing or verification, since a new or verified measurement apparatus 10 is immediately ready to function in the original manner of the replaced measurement apparatus 10, without the need for any programming or configuration by a user. The location of the new measurement apparatus 10 is easy for a user to determine. Additionally, it enables the location of a faulty DUT 20 in the rack to be determined quickly, based on an unexpected voltage or current measurement from an associated measurement apparatus 10.

Errors in the DUT 20 can be readily detected by the firmware of the on-board controller 19 of the measurement apparatus 10. For example, the controller 19 can be externally configured to compare measurements on each channel against individual thresholds, which trigger the output of an alarm signal if a threshold is exceeded, or if a condition is not satisfied. In this way, errors can be detected on a continuous basis, substantially in real time, on-board the measurement apparatus 10, without the need for external communication, with much higher frequency than if errors were to be detected only by an external computing system. In cases in which a large number of measurement channels are present in the test rack 40 (for example, 16 per DUT) with a plurality of DUTs 20, such rapid identification of an error is particularly advantageous.

Although embodiments of the present disclosure are described in the context of testing electrical characteristics of an automotive infotainment system, the measurement apparatus 10 is suitable for use with any DUT where there is a desire to test operation in different power modes (for example, 'on' and 'standby' modes). In such modes, different d.c. power supply voltages are often used, particularly standardized voltages such as 5V, 12V, 24V, which renders the automatic current-range selection mechanism of the current testing module 12 particularly advantageous. Industrial controllers, home automation devices, consumer electronics, radars, cameras, safety devices and communication modules are all examples of devices operating at low and medium power voltages (less than 35V) in which d.c. voltages and analogue outputs are particularly suitable for being tested.

The measurement apparatus 10 of the embodiments of the disclosure enables a number of technical simplifications and associated cost savings, in the context of testing a DUT 20. The ability to test multiple independent channels ensures that it is not necessary to separately configure independent test devices for each channel. In doing so, routing of test signals to specific multimeter connections is avoided, while many conventional test systems can be replaced by a single measurement apparatus.

Both the selection of the number of voltage testing modules 13a-n, and the number of voltage testing units in each voltage testing module 13a-n enable flexibility and expansion of the complexity of the DUT 20 which can be tested, and the construction of a modular test system in which significant testing capability can be added each time a single measurement apparatus is added to the test system.

The output of digitized measurement information facilitates its onward processing by a results-processing system 47. In this way, the measurement apparatus 10 can be regarded as digitizer of measurements, and the base board 11 is also referred to herein as a 'digitizer base board'. Robust communication of the digitized results reduces operator intervention and the need for additional testing staff.

In the present disclosure, references to a controller are considered to represent processors for executing one or more computer-readable instructions for performing the functions described. The controllers may, in embodiments, use hard-coded hardware implementations instead of, or in addition to software-based implementations, where appropriate. For simplicity, specific details associated with the controllers, such as power supplies, storage of computer-executable instructions, and communications links are not shown in the interests of conciseness, but it will be readily understood by those skilled in the art how such components would be configured in embodiments of the present disclosure.

## Claims

1. An apparatus for measuring electrical characteristics of a test system, comprising:
a base board arranged to host a plurality of circuit boards, each circuit board comprising a measurement module, the base board comprising an interface for connection with the test system;
wherein the interface is arranged to receive a current, on a current channel, from the test system, and a plurality of voltages, on a respective plurality of voltage channels, from the test system;
wherein the plurality of circuit boards comprises:
one or more voltage testing modules, each voltage testing module comprising a plurality of voltage measurement units, and each voltage measurement unit for measuring a voltage on a respective voltage channel;
a current testing module for measuring a current on the current channel;
wherein the interface is arranged to output voltage information from the one or more voltage testing modules and current information from the current testing module.

2. An apparatus according to claim 1, wherein each of the one or more voltage testing modules comprises a sampler for sampling the voltage on a voltage channel, an analogue to digital converter for determining a digital voltage level for the sampled voltage, and a storage means for storing the digital voltage level,
wherein the interface is arranged to output the stored digital voltage level for each voltage channel in parallel.

3. An apparatus according to claim 2, wherein the storage means is arranged to store an average of a plurality of digital voltage levels and the interface is arranged to output the stored average.

4. An apparatus according to any one of claims 1 to 3, wherein the current testing module comprises a plurality of current measurement paths, wherein each current measurement path is for measuring current within a predetermined range,
the current testing module comprising a selector for automatically routing the current channel to a current measurement path in dependence upon the level of the current to be measured.

5. An apparatus according to claim 4,
wherein each current measurement path comprises:
a shunt resistor having a resistance dependent on the predetermined range of the current measurement path; and
an instrumentation amplifier for measuring a voltage across the shunt resistor when current passes through the shunt resistor;
wherein the selector is arranged to switch the current channel from a first current measurement path to a second current measurement path if a voltage output by an instrumentation amplifier of the first current measurement path exceeds a threshold.

6. An apparatus according to claim 5, wherein the shunt resistors are connected in series,
wherein the shunt resistor of the first current measurement path is connected in parallel with a bypass switch arranged to close if the voltage output by the instrumentation amplifier of the first current measurement path exceeds the threshold.

7. An apparatus according to claim 5 or claim 6, wherein the resistances of the shunt resistors are selectable via a control signal received by the current testing module in dependence on selection of the predetermined current measurement range of each current measurement path.

8. An apparatus according to claim 6 or claim 7, further comprising:
a sampler for sampling a voltage output by the instrumentation amplifier of a current measurement channel;
an analogue to digital converter for outputting a digital current level corresponding to each sampled voltage and the resistance of the shunt of the current measurement channel; and
a storage means for storing the digital current levels,
wherein the interface is arranged to output the stored digital current levels.

9. An apparatus according to claim 8, wherein the storage means is arranged to store an average of a plurality of digital current levels and the interface is arranged to output the stored average.

10. A test rack comprising an electromagnetic compatibility chamber, and a plurality of apparatuses according to any one of the preceding claims, wherein the plurality of apparatuses are mounted within the electromagnetic compatibility chamber and each one of the plurality of apparatuses is arranged to measure electrical characteristics of a respective test system to be mounted to the test rack.

11. A test rack according to claim 10, wherein the interface of each apparatus is arranged to connect to the respective test system using an ethernet connection or optical fibre connection.

12. A test rack according to claim 10 or claim 11, wherein each apparatus is arranged to output information identifying the address of the apparatus in the test rack.

13. A test rack according to any one of claims 10 to 12, comprising a backplane for receiving the respective plurality of base boards of the plurality of apparatuses.

14. A test rack according to any one of claims 10 to 13, arranged to receive a plurality of automotive infotainment systems as the plurality of test systems.

## Amended claims

### Amended claims in accordance with Rule 137(2) EPC.

1. An apparatus (10) for measuring electrical characteristics of a test system (20), comprising:
a base board (11) arranged to host a plurality of circuit boards, each circuit board comprising a measurement module, the base board comprising an interface (14) for connection with the test system;
wherein the interface is arranged to receive a current, on a current channel (15), from the test system, and a plurality of voltages, on a respective plurality of voltage channels (16a-n), from the test system;
wherein the plurality of circuit boards comprises:
one or more voltage testing modules (13a-n), each voltage testing module comprising a plurality of voltage measurement units (27), and each voltage measurement unit for measuring a voltage on a respective voltage channel;
a current testing module (12) for measuring a current on the current channel;
wherein the interface is arranged to output voltage information from the one or more voltage testing modules and current information from the current testing module,
the apparatus further comprising an interface for mounting to a test rack (40), the apparatus having physical dimensions so as to be accommodated within an electromagnetic compatibility chamber (41) of the test rack when mounted to the test rack.

2. An apparatus according to claim 1, wherein each of the one or more voltage testing modules (13a-n) comprises a sampler (24) for sampling the voltage on a voltage channel, an analogue to digital converter (25) for determining a digital voltage level for the sampled voltage, and a storage means (26) for storing the digital voltage level,
wherein the interface (14) is arranged to output the stored digital voltage level for each voltage channel in parallel.

3. An apparatus according to claim 2, wherein the storage means (26) is arranged to store an average of a plurality of digital voltage levels and the interface (14) is arranged to output the stored average.

4. An apparatus according to any one of claims 1 to 3, wherein the current testing module (12) comprises a plurality of current measurement paths (50, 51 52), wherein each current measurement path is for measuring current within a predetermined range,
the current testing module comprising a selector (28) for automatically routing the current channel to a current measurement path in dependence upon the level of the current to be measured.

5. An apparatus according to claim 4,
wherein each current measurement path comprises:
a shunt resistor (35a-c) having a resistance dependent on the predetermined range of the current measurement path; and
an instrumentation amplifier (34a-c) for measuring a voltage across the shunt resistor when current passes through the shunt resistor;
wherein the selector (28) is arranged to switch the current channel from a first current measurement path (50) to a second current measurement path (51) if a voltage output by an instrumentation amplifier (34a) of the first current measurement path exceeds a threshold.

6. An apparatus according to claim 5, wherein the shunt resistors are connected in series,
wherein the shunt resistor (35a) of the first current measurement path is connected in parallel with a bypass switch (36) arranged to close if the voltage output by the instrumentation amplifier (34a) of the first current measurement path exceeds the threshold.

7. An apparatus according to claim 5 or claim 6, wherein the resistances of the shunt resistors (35a-c) are selectable via a control signal (32) received by the current testing module in dependence on selection of the predetermined current measurement range of each current measurement path (50, 51, 52).

8. An apparatus according to claim 6 or claim 7, further comprising:
a sampler for sampling a voltage output by the instrumentation amplifier of a current measurement channel;
an analogue to digital converter (29) for outputting a digital current level corresponding to each sampled voltage and the resistance of the shunt of the current measurement channel; and
a storage means for storing the digital current levels,
wherein the interface (14) is arranged to output the stored digital current levels.

9. An apparatus according to claim 8, wherein the storage means is arranged to store an average of a plurality of digital current levels and the interface (14) is arranged to output the stored average.

10. A test rack (40) comprising the electromagnetic compatibility chamber (41), and a plurality of apparatuses (10) according to any one of the preceding claims, wherein the plurality of apparatuses are mounted within the electromagnetic compatibility chamber and each one of the plurality of apparatuses is arranged to measure electrical characteristics of a respective test system (20) to be mounted to the test rack.

11. A test rack according to claim 10, wherein the interface of each apparatus (10) is arranged to connect to the respective test system using an ethernet connection or optical fibre connection.

12. A test rack according to claim 10 or claim 11, wherein each apparatus is arranged to output information identifying the address of the apparatus in the test rack.

13. A test rack according to any one of claims 10 to 12, comprising a backplane (42) for receiving the respective plurality of base boards (11) of the plurality of apparatuses (10).

14. A test rack according to any one of claims 10 to 13, arranged to receive a plurality of automotive infotainment systems as the plurality of test systems (20).
